# EUROPEAN PATENT APPLICATION

(11) **EP 2 366 460 A2**
(43) Date of publication of application: **21.09.2011**
(21) Application number: 10195162.2
(22) Date of filing: 15.12.2010
(51) Int. Cl.: B06B 1/06, G07D 7/08, H01L 41/22, G01N 29/24, G07D 7/16, G07D 11/00

(54) **Method for manufacturing ultrasonic sensor, ultrasonic sensor, and banknote handling apparatus comprising ultrasonic sensor**

(30) Priority: 18.03.2010 JP 2010063325
(71) Applicant: Kabushiki Kaisha Toshiba, Minato-ku, Tokyo 105-8001 (JP)
(72) Inventor: Yamamoto, Takahiro, Tokyo Tokyo 105-8001 (JP); Itsumi, Kazuhiro, Tokyo Tokyo 105-8001 (JP)
(74) Representative: Horn Kleimann Waitzhofer

(57) **Abstract**

According to one embodiment, a method for manufacturing an ultrasonic sensor includes forming a first conductive layer (632a) on one side of a piezoelectric body (631) having opposing sides; forming a second conductive layer (632b) on the other side of the piezoelectric body (631); forming a backing layer (640) on the first conductive layer (632a); forming a matching layer (610) of a size corresponding to a size of a conveyed object to be detected on the second conductive layer; and providing at least one incision (G) that cuts through the first conductive layer (632a), the piezoelectric body (631), the second conductive layer (632b) and the matching layer (610), the incisions (G) having a depth extending from the matching layer (610) to at least the first conductive layer (632a), to form a plurality of channels (C).

## Description

### FIELD

Exemplary embodiments described herein relate to methods for manufacturing an ultrasonic sensor for detecting ultrasonic waves, to ultrasonic sensors and to banknote handling apparatuses comprising an ultrasonic sensor.

### BACKGROUND

Conventionally, sheet handling apparatuses (banknote handling apparatuses) have been put into practice that count and discriminate various types of sheets. A sheet handling apparatus takes in sheets inserted into an insert port one by one, and conveys the sheets to an inspection device. The inspection device subjects the sheets to various sorts of processing and discriminates the state of the sheet. For example, the sheet handling apparatus may carry out a judgment on the type of the sheet, and a judgment on whether the banknote is genuine or false, based on the inspection result of the inspection device.

Moreover, the sheet handling apparatus may judge that for example a sheet to which foreign material, such as tape, is stuck is not fit for recirculation. For example, the inspection device may irradiate an ultrasonic wave onto the sheet, and detect the presence of foreign material, such as tape sticking to the sheet, by detecting a transmitted wave or a reflected wave.

Also known is a technology, in which an ultrasonic probe is used, in which the acoustic impedance of an object is detected by irradiating an ultrasonic wave onto the object and receiving a reflection echo.

The sheet handling apparatus transports sheets at a predetermined conveying speed, and detects certain features from the conveyed sheets. Thus, the sheet handling apparatus performs the inspection of the sheets. For this reason, if the above-described ultrasonic probe or the like is used in a sheet handling apparatus, then it may be necessary to adapt the sensor of the ultrasonic probe to the sheet handling apparatus. That is to say, it may be necessary to manufacture an ultrasonic probe having a sensor with a resolution corresponding to the specification of the sheet handling apparatus.

However, if an ultrasonic probe with a different resolution is manufactured, it may be necessary to combine a piezoelectric element, an acoustic matching layer, and an acoustic backing layer individually. For this reason, when manufacturing an ultrasonic sensor used in a sheet handling apparatus, there is the problem of rising costs.

### SUMMARY OF THE INVENTION

It is an object of the present invention to provide a method for manufacturing an ultrasonic sensor, an ultrasonic sensor and a banknote handling apparatus comprising an ultrasonic sensor, with which the resolution of the sensor can be easily changed.

### BRIEF DESCRIPTION OF THE DRAWINGS

FIG. 1 is a perspective view showing the appearance of a sheet handling apparatus in accordance with one embodiment;

FIG. 2 is a diagrammatic front view showing a configuration example of the sheet handling apparatus shown in FIG. 1;

FIG. 3 is a block diagram showing a configuration example of a control system of the sheet handling apparatus shown in FIG. 1 and FIG. 2;

FIG. 4 is a perspective view showing the foreign material detecting device shown in FIG. 2 and FIG. 3;

FIG. 5 is a partial cross-sectional view showing the sensor of the foreign material detecting device shown in FIG. 4;

FIG. 6 is a partial cross-sectional view showing the sensor of the foreign material detecting device shown in FIG. 4;

FIG. 7 is a plan view to illustrate the operation of the sensor of the foreign material detecting device shown in FIG. 4;

FIG. 8 is a partial sectional view to illustrate a method for manufacturing a sensor of the foreign material detecting device shown in FIG. 4;

FIG. 9 is a partial sectional view to illustrate a method for manufacturing the sensor of the foreign material detecting device shown in FIG. 4;

FIG. 10 is a partial sectional view to illustrate a method for manufacturing the sensor of the foreign material detecting device shown in FIG. 4;

FIG. 11 is a partial sectional view to illustrate a method for manufacturing the sensor of the foreign material detecting device shown in FIG. 4;

FIG. 12 is a partial sectional view to illustrate a method for manufacturing the sensor of the foreign material detecting device shown in FIG. 4;

FIG. 13 is a partial sectional view to illustrate a method for manufacturing the sensor of the foreign material detecting device shown in FIG. 4;

FIG. 14 is a block diagram to illustrate a configuration example of the foreign material detecting device shown in FIG. 4;

FIG. 15 is a diagrammatic view showing an example and a graph of a signal detected by the foreign material detecting device shown in FIG. 4;

FIG. 16 is a diagram showing another dicing example of the sensor of the foreign material detecting device shown in FIG. 4;

FIG. 17 is a diagram showing the positional relation between a transmission sensor and a receiving sensor of the foreign material detecting device shown in FIG. 4; and

FIG. 18 is a diagram showing another configuration example of the transmission sensor of the foreign material detecting device shown in FIG. 4.

### DETAILED DESCRIPTION

In general, according to one embodiment, there is provided a method for manufacturing an ultrasonic sensor comprising forming a first conductive layer on one side of a piezoelectric body having opposing sides; forming a second conductive layer on the other side of the piezoelectric body; forming a backing layer on the first conductive layer; forming a matching layer of a size corresponding to a size of a conveyed object to be detected on the second conductive layer; and providing incisions that through the first conductive layer, the piezoelectric body, the second conductive layer and the matching layer, the incisions having a depth extending from the matching layer to at least the first conductive layer, to form a plurality of channels.

Referring to the accompanying drawings, the following is a detailed explanation of a method for manufacturing an ultrasonic sensor, an ultrasonic sensor and a banknote handling apparatus comprising an ultrasonic sensor in accordance with an embodiment of the present invention.

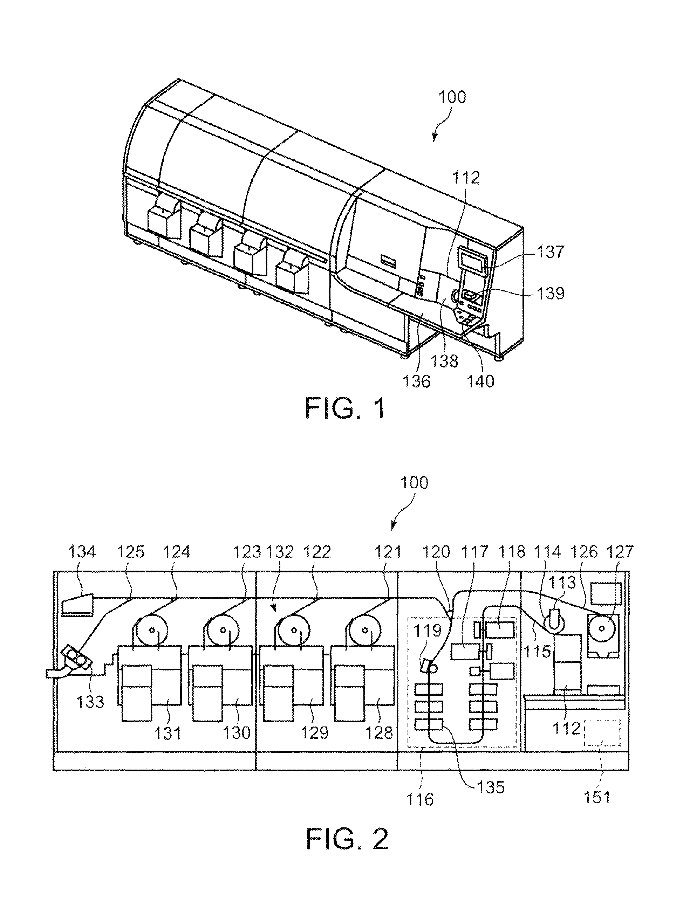

FIG. 1 is a perspective view showing the appearance of a sheet handling apparatus (banknote handling apparatus) 100 in accordance with one embodiment. As shown in FIG. 1, the sheet handling apparatus 100 includes, on the outside of the apparatus, an insert port 112, an operating portion 136, an operation/display portion 137, a door 138, a take-out port 139 and a keyboard 140.

The insert port 112 is configured so that sheets 7, for example banknotes, can be inserted into it. The insert port 112 receives a batch of stacked sheets 7. The operating portion 136 receives various operation inputs from an operator. The operation/display portion 137 displays various kinds of operation guidance and processing results to the operator.

It should be noted that the operation/display portion 137 may also be configured as a touch panel. In this case, the sheet handling apparatus 100 senses various kinds of operation inputs based on buttons that are displayed on the operation/display portion 137, and the operation by the operator on the operation/display portion 137.

The door 138 is for opening and closing the insert opening of the insert port 112. The take-out port 139 is configured to retrieve the sheets 7 from a collection portion where the sheets 7 that have been judged by the sheet handling apparatus 100 to be unfit for recirculation are stacked. The keyboard 140 functions as an input section that receives various kinds of operation input from the operator.

FIG. 2 is a diagrammatic view to illustrate a configuration example of the sheet handling apparatus 100 shown in FIG. 1. The sheet handling apparatus 100 includes, on the inside of the apparatus, the insert port 112, a take-out port 113, a suction roller 114, a conveying route 115, an inspection portion 116, gates 120 to 125, a rejection sheet conveying route 126, a rejection sheet stacker 127, stack/band portions 128 to 131, a cutting portion 133, and a stacker 134. Moreover, the sheet handling apparatus 100 includes a main controller 151. The main controller 151 performs the integrated control of the operation of the various parts of the sheet handling apparatus 100.

The take-out port 113 is arranged above the insert port. The take-out port 113 includes the suction roller 114. The suction roller 114 is provided such that it contacts the sheets 7 placed into the insert port 112 at the upper end in stacking direction. That is to say, by rotating, the suction roller 114 takes in the sheets 7 placed in the insert port 112 one by one from the upper end in stacking direction into the apparatus. The suction roller 114 functions so as to take out one sheet 7 per rotation, for example. Thus, the suction roller 114 takes out the sheets 7 at constant pitch. The sheets 7 taken out by the suction roller 114 are introduced to the conveying route 115.

The conveying route 115 is a conveying unit for conveying the sheets 7 to the various parts inside the sheet handling apparatus 100. The conveying route 115 is provided with conveying belts and drive pulleys that are not shown in the drawings. The conveying route 115 causes the conveying belts to operate with a drive motor and drive pulleys not shown in the drawings. The conveying route 115 conveys the sheet 7 taken out by the suction roller 114 at a constant speed with the conveying belts. It should be noted that in the following explanations, the side of the conveying route 115 closer to the take-out port 113 is regarded as the "upstream side", and the side of the conveying route 115 closer to the stacker 134 is regarded as the "downstream side".

The inspection portion 116 is provided on the conveying route 115 extending from the take-out port 113. The inspection portion 116 includes an image reader 117, an image reader 118, a foreign material detecting device 135, and a thickness inspection portion 119. The inspection portion 116 detects optical feature information, mechanical features, and magnetic feature information of the sheets 7. Thus, the sheet handling apparatus 100 inspects the type, damage and dirt, front and back surface, and the genuineness of the sheets 7.

The image readers 117 and 118 are arranged on opposite sides flanking the conveying route 115. The image readers 117 and 118 read the images of both sides of the sheets 7 that are conveyed along the conveying route 115. The image readers 117 and 118 each include a charge-coupled device (CCD) camera. The sheet handling apparatus 100 obtains pattern images of the front surface and the back surface of the sheets 7, based on the images taken with the image readers 117 and 118.

The image readers 117 and 118 temporarily store the read images in a memory, which is not shown in the drawings, inside the inspection portion 116. The sheet handling apparatus 100 displays the images stored in this memory on the operation/display portion 137, in accordance with the operation input.

The foreign material detecting device 135 irradiates ultrasonic waves onto the conveyed sheet 7, and detects a transmission wave that is transmitted through the sheet 7. Thus, the foreign material detecting device 135 detects the presence of foreign material adhering to the sheet 7, for example. The foreign material detecting device 135 detects for example a piece of tape or the like that is stuck on the sheet as foreign material.

The thickness inspection portion 119 inspects the thickness of the sheets 7 that are conveyed on the conveying route 115. For example, if the detected thickness has at least a predetermined value, the sheet handling apparatus 100 detects that two sheets 7 have been taken out at the same time.

Moreover, the inspection portion 116 includes a magnetic sensor that is not shown in the drawings. This magnetic sensor detects magnetic feature information concerning the sheets 7.

Based on the detection result from the image readers 117, 118, the foreign material detecting device 135, the thickness inspection portion 119, and the magnetic sensor and the like, the main controller 151 judges whether the sheets 7 are intact bills, damaged bills or rejection bills.

The sheet handling apparatus 100 conveys the sheets 7 that have been judged to be intact bills to the stack/band portions 128 to 131. Moreover, the sheet handling apparatus 100 conveys the sheets 7 that have been judged to be damaged bills to a cutting portion 133. The cutting portion 133 cuts the damaged bills conveyed to it. It should be noted that the sheet handling apparatus 100 may also convey the damaged bills to the stacker 134 and stack them there. The stacker 134 applies a wrapper every time that for example 100 stacked damaged bills have arrived.

The rejection bills are sheets 7 that are neither intact bills nor damaged bills. The sheet handling apparatus 100 conveys the sheets 7 that have been judged to be rejection bills to the rejection sheet stacker 127. Rejection bills are for example improperly conveyed bills, such as double take-outs, defective bills, such as folded or ripped bills, and bills that could not be discriminated, such as wrong bill types or counterfeit bills.

The gates 120 to 125 are arranged in order along the conveying route 115 on the downstream side of the inspection portion 116. The gates 120 to 125 are each controlled by the main controller 151. The main controller 151 controls the operation of the gates 120 to 125 based on the inspection result from the inspection portion 116. Thus, the main controller 151 performs the control such that the sheets 7 conveyed on the conveying route 115 are conveyed to a predetermined processing portion.

The gate 120 arranged immediately behind the inspection portion 116 branches the conveying route 115 to a rejection sheet conveying route 126. That is to say, as a result of the inspection with the inspection portion 116, the gate 120 is switched such that the rejection bills that have been judged not to be legitimate bills, the bills that could not be inspected by the inspection portion 116 and the like are conveyed to the rejection sheet conveying route 126.

The rejection sheet stacker (rejection portion) 127 is provided at the rear end of the rejection sheet conveying route 126. The rejection sheet stacker 127 stacks the above-noted rejection bills, and bills that could not be inspected and so on mentioned above, in the orientation in which they were taken out from the take-out port 113. The sheets 7 stacked in the rejection sheet stacker 127 can be taken out from the take-out port 139.

Moreover, the stack/band portions 128 to 131 (collectively referred to as "stack and band portion 132") are provided respectively behind the branching of the gates 121 to 124. The sheets 7 that have been judged to be fit for recirculation are stacked in the stack and band portion 132, sorted by type and front/back side. The stack and band portion 132 bands and stores the stacked sheets 7 in packs of a predetermined number. Moreover, every predetermined number of packs, the sheet handling apparatus 100 stacks and bands a plurality of packs of sheets 7 with a large-pack band portion, not shown in the drawings.

The cutting portion 133 is arranged behind the branching of the gate 125. The cutting portion 133 cuts and stores sheets 7. The sheets 7 that are conveyed by the gate 125 are legitimate sheets 7 that have been judged to be unfit for recirculation (damaged bills).

The stacker 134 is placed at the end of the other conveying route branched by the gate 125. If the damaged bill cutting mode is selected, the main controller 151 controls the gate 125 such that the sheets 7 are conveyed to the cutting portion 133. And if the damaged bill cutting mode is not selected, the main controller 151 controls the gate 125 such that the sheets 7 are conveyed to the stacker 134.

The main controller 151 successively stores the number of sheets 7 stacked by the stack and band portion 132, the number of sheets 7 cut by the cutting portion 133, and identification information.

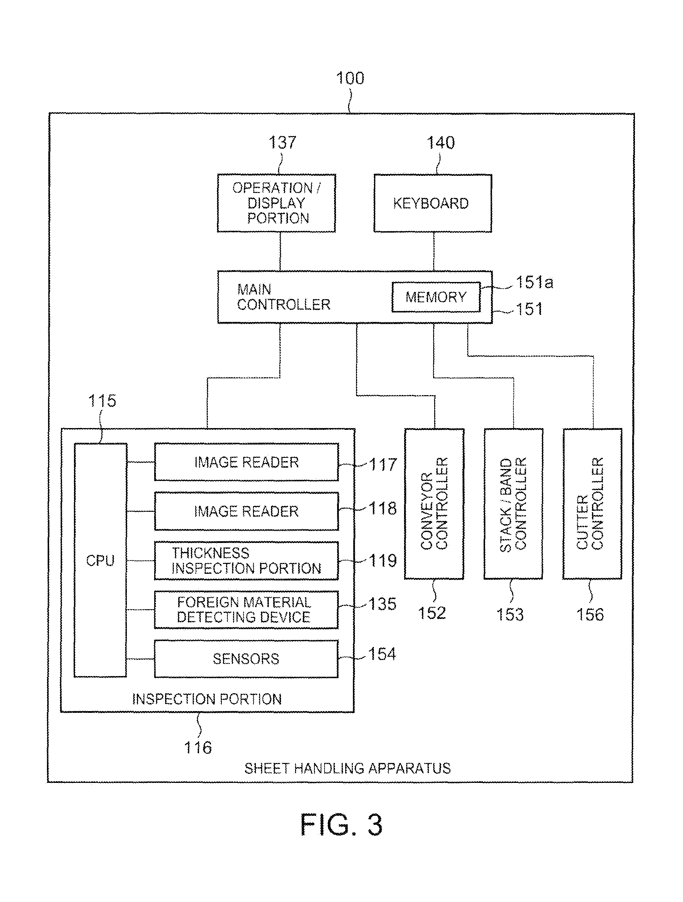

FIG. 3 is a block diagram illustrating a configuration example of a control system of the sheet handling apparatus 100 shown in FIG. 1 and FIG. 2.

The sheet handling apparatus 100 includes the main controller 151, the inspection portion 116, a conveyor controller 152, a stack/band controller 153, a cutter controller 156, the operation/display portion 137, and the keyboard 140.

The main controller 151 performs the overall control of the sheet handling apparatus 100. The main controller 151 controls the conveyor controller 152 and the stack/band controller 153 based on the commands entered into the operation/display portion 137 and the inspection result from the inspection portion 116.

For example, an operator may enter the bill type and number, the intactness discrimination level, the name of the supplier and the processing method of the processed sheets 7 with the operation/display portion 137 or the keyboard 140.

The inspection portion 116 includes the image readers 117 and 118, the thickness inspection portion 119, the foreign material detecting device 135, other sensors 154 and a CPU 155.

The image readers 117 and 118 read an image from both sides of the sheets 7 that are conveyed on the conveying route 115. The image readers 117 and 118 include a light-receiving element, such as a CCD, and an optical system. The image readers 117 and 118 project light onto the conveyed sheets 7 and receive the reflected light or the transmitted light with the optical system. The image readers 117 and 118 image the light received with the optical system onto the CCD and obtain an electric signal (image).

The main controller 151 stores an image (reference image) serving as a reference for the sheet 7 in advance in a memory 151a. The main controller 151 l subjects the sheets to an intactness judgment and a counterfeit bill judgment by comparing the image obtained from the sheets 7 with the reference image stored in the memory 151a.

As described above, the foreign material detecting device 135 irradiates ultrasonic waves onto the conveyed sheets 7. The foreign material detecting device 135 detects the sonic waves that are transmitted through the sheets 7. Furthermore, the foreign material detecting device 135 stores a pre-set reference value.

If foreign material adheres to a sheet 7, then the intensity of the ultrasonic wave that is transmitted through the sheet 7 (transmitted wave) is attenuated. The foreign material detecting device 135 compares the intensity of the detected sonic wave with the pre-stored reference value. Based on the comparison result, the foreign material detecting device 135 determines whether foreign material adheres to the sheet 7.

The thickness inspection portion 119 inspects the thickness of the sheets 7 that are conveyed on the conveying route 115. The other sensors 154 are for example magnetic sensors or the like. The magnetic sensors detect information on magnetic features from the sheets 7 that are conveyed on the conveying route 115.

Based on the result of the inspection with the image readers 117 and 118, the thickness inspection portion 119, the foreign material detecting device 135, and the other sensors 154, the CPU 155 discriminates the type, the intactness, the front and back surface and the genuineness of the sheets 7 that are conveyed on the conveying route 115.

Based on the control of the main controller 151, the conveyor controller 152 controls the take-out port 113, the conveying route 115, the rejection sheet conveying route 126, and the gates 120 to 125. Accordingly, the conveyor controller 152 controls the take-out and the conveying of the sheets 7. Moreover, the conveyor controller 152 performs a sorting process, in which the judged sheets 7 are sorted by type. That is to say, the conveyor controller 152 functions as a sorting processor.

For example, if the foreign material detecting device 135 detects that foreign material adheres to a sheet 7, then the conveyor controller 152 controls the gates 120 to 125 such that the sheet 7 is conveyed to the rejection sheet stacker 127, the cutting portion 133 or the stacker 134.

The stack/band controller 153 controls the rejection sheet stacker 127 and the stack/band portions 128 to 131 based on the control of the main controller 151. Thus, the stack/band controller 153 controls the stacking and the banding of the sheets 7.

The cutter controller 156 controls the operation of the cutting portion 133 based on the control of the main controller 151. Thus, the cutting portion 133 performs the cutting of the conveyed sheets 7.

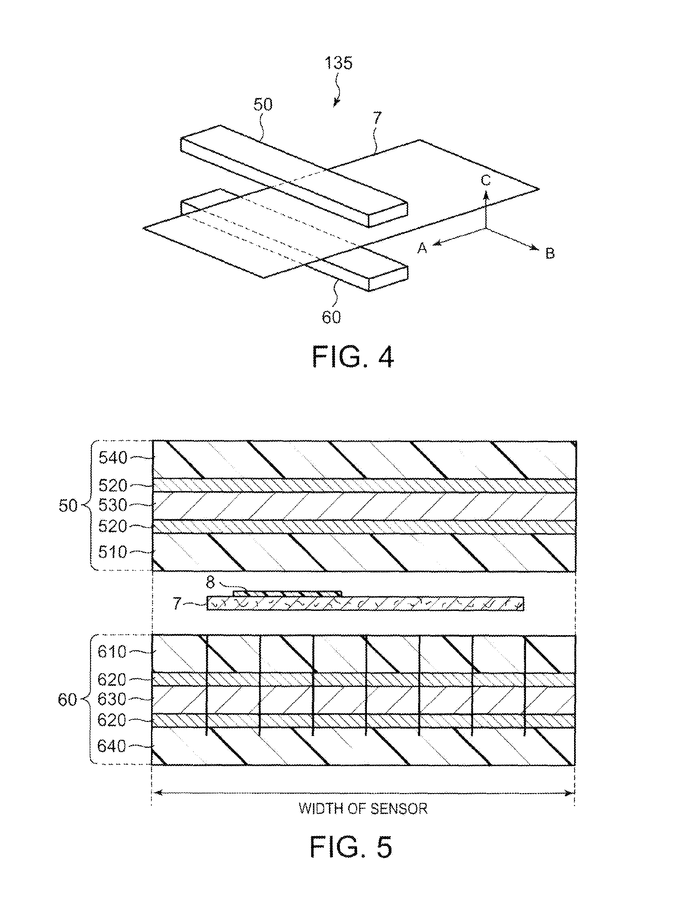

FIG. 4 is a perspective view showing the foreign material detecting device 135 shown in FIG. 2 and FIG. 3. The foreign material detecting device 135 performs a detection process to detect foreign material, such as a tape adhering to the sheet 7. Thus, the foreign material detecting device 135 detects the presence of foreign material adhering to the sheet 7. The foreign material detecting device 135 is placed near the conveying route 115 of the sheet handling apparatus 100, for example. As shown in FIG. 4, the foreign material detecting device 135 includes a transmission sensor 50 and a receiving sensor 60. Note that the arrow A in FIG. 4 indicates the conveying direction of the sheet 7. The arrow B indicates the cross direction (width direction) of the conveyed sheet 7. The arrow C indicates the vertical direction.

The transmission sensor 50 is a transmission portion that irradiates ultrasonic waves onto the sheet 7, which is conveyed at a constant speed in the conveying direction A. The transmission sensor 50 is arranged at a position opposing the receiving sensor 60, such the conveying route 115 is arranged between the transmission sensor 50 and the receiving sensor 60. The transmission sensor 50 comprises a piezoelectric element. The piezoelectric element includes a piezoelectric body as well as a pair of electrodes arranged to hold the piezoelectric body between them.

By applying a voltage to the electrodes of the piezoelectric element, the transmission sensor 50 changes the shape of the piezoelectric body. Thus, the piezoelectric element of the transmission sensor 50 expands and contracts in the vertical direction C. By applying a pulse signal to the electrodes of the piezoelectric element, the transmission sensor 50 causes the piezoelectric body to oscillate. As a result, the transmissions sensor 50 generates an ultrasonic wave.

The receiving sensor 60 is a receiving portion that detects the transmission wave that has been emitted from the transmission sensor 50 and transmitted through the sheet 7. The receiving sensor 60 is arranged at a position opposing the transmission sensor 50, such that the conveying route 115 is arranged between the transmission sensor 50 and the receiving sensor 60. The receiving sensor 60 includes a piezoelectric element, just like the transmission sensor 50.

The receiving sensor 60 generates a signal corresponding to the change of the shape of its piezoelectric body. If an ultrasonic wave is irradiated onto the receiving sensor 60, the piezoelectric body changes its shape in accordance with the intensity and cycle length of the ultrasonic wave. That is to say, the receiving sensor 60 generates a signal in accordance with the intensity and cycle length of the ultrasonic wave. Thus, the receiving sensor 60 detects a transmission wave transmitted through the sheet 7.

FIG. 5 is a partial cross-sectional view showing a configuration example of the transmission sensor 50 and the receiving sensor 60 of the foreign material detecting device 135 shown in FIG. 4. FIG. 5 is a diagram in which the foreign material detecting apparatus 135 is viewed from the conveying direction A. FIG. 5 shows the transmission sensor 50, the receiving sensor 60, the sheet 7, and foreign material 8 adhering to the sheet 7 respectively in cross section.

The transmission sensor 50 and the receiving sensor 60 are both provided with a predetermined size (sensor width) in the width direction B. As long as the transmission sensor 50 and the receiving sensor 60 have a configuration in which their sensor width is at least the width over which the sheet 7 is conveyed, they may be of any size.

The transmission sensor 50 includes a matching layer 510, flexible printed circuit boards (FPC) 520, a piezoelectric element 530, and a backing layer 540.

Moreover, the receiving sensor 60 includes a matching layer 610, FPCs 620, a piezoelectric element 630, and a backing layer 640. It should be noted that the configuration of the transmission sensor 50 is the same as the configuration of the receiving sensor 60, so that the configuration of the receiving sensor 60 is explained as an example.

The matching layer 610 is configured such that ultrasonic waves are propagated efficiently between the receiving sensor 60 and air. Ordinarily, there is a large difference between the acoustic impedance of the piezoelectric body and the acoustic impedance of air. Therefore, the transmission loss of the supersonic wave oscillations at their interface is large.

The matching layer 610 is configured to have an acoustic impedance that is intermediate between the acoustic impedance of the piezoelectric body and the acoustic impedance of air. By providing the matching layer 610 between the piezoelectric element 630 and the air, the receiving sensor 60 can efficiently detect the ultrasonic waves propagated through the air.

It should be noted that the matching layer 610 is bonded to the piezoelectric element 630 through one of the FPCs 620. Therefore, the matching layer 610 oscillates together with the piezoelectric element 630.

The FPCs 620 are components, in which a circuit or the like is formed with a copper foil on an electrically insulating film having flexibility. The FPCs 620 can be bent, stacked, folded, rolled up and twisted.

The FPCs 620 sandwich the piezoelectric element 630. The sides of the FPCs 620 on which the copper foil is printed are electrically connected to the electrodes of the piezoelectric element 630.

It should be noted that the FPCs 620 are not essential elements, and a configuration is possible, in which electrodes that can be connected from the outside are provided at least on both sides of the piezoelectric body. That is to say, it is also possible to replace the FPCs 620 by other elements, or to omit them.

The piezoelectric element 630 includes the piezoelectric body, which may be a quartz crystal or a ceramic or the like, and the electrodes arranged on both sides of the piezoelectric body. The piezoelectric body displays the piezoelectric effect of oscillating in accordance with the cycle period and intensity of the applied pulse signal when a pulse signal is applied. Thus, the piezoelectric body can convert an electric signal into an ultrasonic wave. Furthermore, the piezoelectric body can convert an ultrasonic wave into an electric signal.

The backing layer 640 absorbs acoustic energy (oscillations) that are radiated from the piezoelectric element 630 to the reverse side (back side) of the matching layer 610. Moreover, the backing layer 640 suppresses free oscillations of the piezoelectric element 630.

It should be noted that the matching layer 610, the FPCs 620 and the piezoelectric element 630 of the receiving sensor 60 are cut into a plurality of channels C by a dicing process, which is explained later. Thus, the receiving sensor 60 can detect supersonic waves from different regions corresponding to the various channels C.

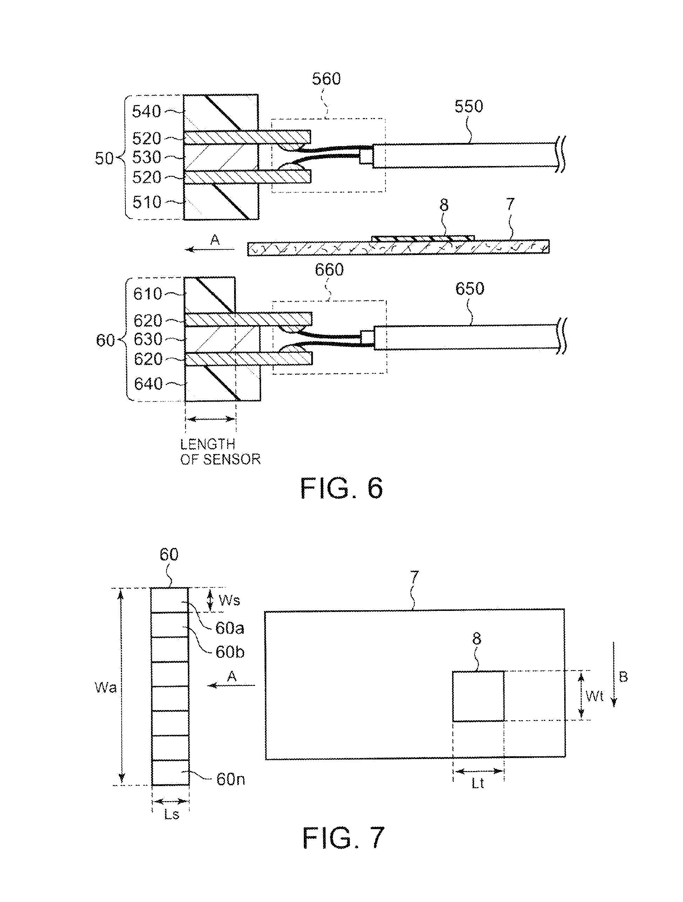

FIG. 6 is a partial cross-sectional view showing a configuration example of the transmission sensor 50 and the receiving sensor 60 of the foreign material detecting device 135 shown in FIG. 4. FIG. 6 is a diagram in which the foreign material detecting apparatus 135 is viewed from the width direction B.

As shown in FIG. 6, the transmission sensor 50 is connected to a coaxial cable 550. That is to say, in a connecting portion 560, the sides of the FPCs 520 of the transmission sensor 50 on which the copper foil is printed are connected to a plus-terminal or a minus-terminal of the coaxial cable 550. Thus, the transmission sensor 50 is electrically connected to a transmission pulse generator or the like, which generates the pulse signal, for example.

That is to say, when a pulse signal is entered through the coaxial cable 550 into the transmission sensor 50, a voltage corresponding to the pulse signal is applied to the piezoelectric body of the piezoelectric element 530.

Also the receiving sensor 60 is similarly connected to a coaxial cable 650. That is to say, in a connecting portion 660, the sides of the FPCs 620 of the receiving sensor 60 on which the copper foil is printed are connected to a plus-terminal or a minus-terminal of the coaxial cable 650. Thus, the receiving sensor 60 is electrically connected to a reading circuit or the like, which reads in the detection signal generated by the piezoelectric element 630, for example.

That is to say, if supersonic waves are irradiated onto the receiving sensor 60, the signal generated by the piezoelectric element 630 is entered via the coaxial cable 650 into the reading circuit.

It should be noted that a coaxial cable 650 is connected to the receiving sensor 60 for each of the channels into which the piezoelectric element is cut. Thus, the receiving sensor 60 can transmit the signals detected in the respective channels to the reading circuit.

FIG. 7 is a diagrammatic view to illustrate a configuration example of the sensors of the foreign material detecting device 135 shown in FIG. 4.

As shown in FIG. 7, the receiving sensor 60 has a sensor width Wa in the width direction B. The channels 60a, 60b --- 60n of the receiving sensor 60 are cut into width Ws in the width direction B. As noted above, by cutting the receiving sensor 60 into a plurality of channels 60a, 60b --- 60n, each of the channels 60a, 60b --- 60n can detect ultrasonic waves from a different region.

For example, the receiving sensor 60 detects ultrasonic waves continuously at predetermined intervals. Thus, the receiving sensor 60 can detect an ultrasonic wave transmitted through the conveyed sheet 7 in each of the predetermined regions.

It should be noted that it is preferable that the length of the matching layer 610 of the receiving sensor 60 in the conveying direction A (sensor length Ls) is less than half the length of the detected foreign material (tape) 8 in the conveying direction A (tape length Lt).

Moreover, it is preferable that the length of the matching layer 610 of the receiving sensor 60 in the width direction B (sensor width Ws) is less than half the length of the detected foreign material (tape) 8 in the width direction B (tape width Wt).

If the sensor length Ls is half the tape length Lt or more or the sensor width Ws is half the tape width Wt or more, then there is the possibility that the detection range of the channels 60a, 60b --- 60n of the receiving sensor 60 overlaps the edges of the adherence range of the tape 8 on the sheet 7. In this case, there is the possibility that the receiving sensor 60 cannot detect the attenuation of the supersonic wave sufficiently to discriminate whether a tape 8 is stuck on or not.

If the sensor length Ls is less than half the tape length Lt and the sensor width Ws is less than half the tape width Wt, then at one of two consecutive timings, the detection range of at least one of the channels lies within the sticking range in which the tape 8 is stuck to the sheet. Thus, the receiving sensor 60 can detect the attenuation of the supersonic wave sufficiently to discriminate whether a tape 8 is stuck to the sheet or not.

It should be noted that it was explained that the sensor length Ls is less than half the tape length Lt and the sensor width Ws is less than half the tape width Wt, but there is no limitation to this. As long as the attenuation of supersonic waves can be detected sufficiently to discriminate whether a tape 8 is stuck to the sheet, the matching layer 610 may be of any size.

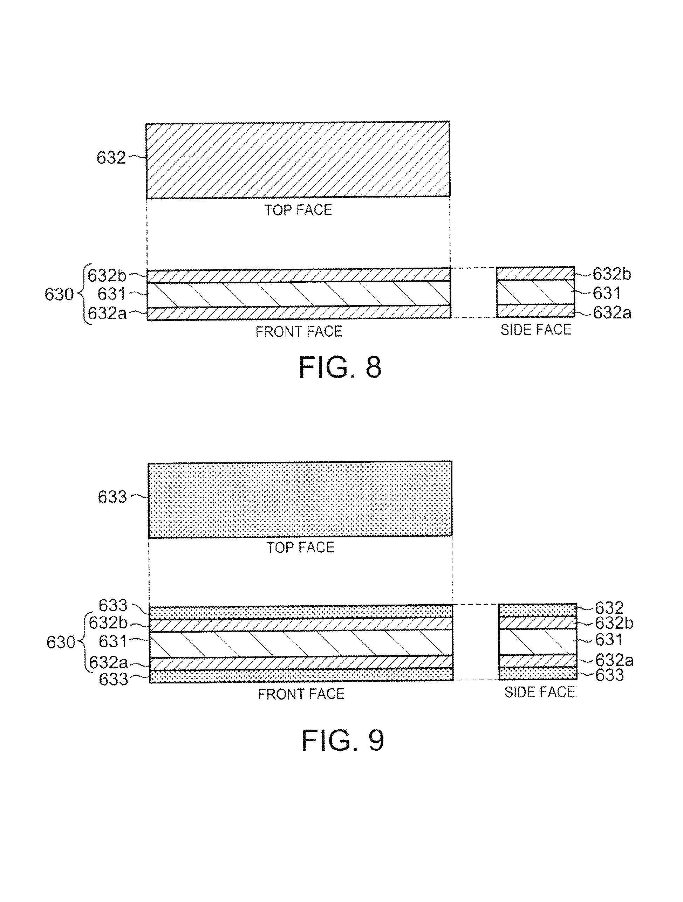

The following is an explanation of steps for manufacturing the transmission sensor 50 and the receiving sensor 60. FIGS. 8 to 12 are partial sectional views illustrating a method for manufacturing the transmission sensor 50 and the receiving sensor 60 of the foreign material detecting apparatus 135 shown in FIG. 4. It should be noted that the steps for manufacturing the transmission sensor 50 are a duplication of the steps for manufacturing the receiving sensor 60, and in the following, the steps for manufacturing the receiving sensor 60 are explained as an example.

FIG. 8 is a diagram showing the top face, the front face and the side face of the piezoelectric element 630. If the piezoelectric element 630 is arranged as a receiving sensor 60, then the top view corresponds to the view seen from the perpendicular direction C. Moreover, the front view corresponds to the view seen from the conveying direction A. And the side view corresponds to the view seen from the width direction B. Here, the top view and the side view are shown as sectional views.

As shown in FIG. 8, the piezoelectric element 630 includes a piezoelectric body 631 and copper foil layers 632a and 632b made of conductive layers arranged on the surface of the piezoelectric body 631. The piezoelectric body 631 is made of a quartz crystal or a ceramic, for example. The first copper foil layer 632a is made of a copper foil or the like that is applied to one side of the piezoelectric body 631, for example, and the second copper foil layer 632b is made of a copper foil or the like that is applied to the other side of the piezoelectric body 631, for example. That is to say, the piezoelectric body 631 is sandwiched between the first copper foil layer 632a and the second copper foil layer 632b.

Next, as shown in FIG. 9, an epoxy resin is applied thinly to the surface of the copper foil layers 632a and 632b. Thus, adhesion layers 633 are formed. The epoxy resin is a conductive resin adhesive.

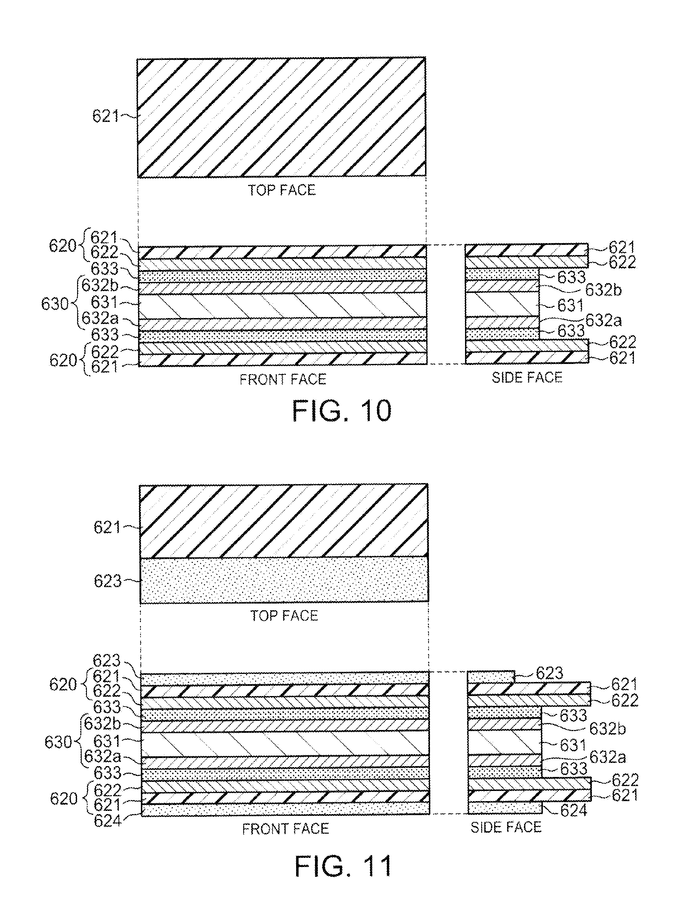

Next, as shown in FIG. 10, the FPCs 620 are adhesively bonded onto the adhesion layers 633. The FPCs 620 and the piezoelectric element 630 are pressed together at suitable pressure while sandwiching the adhesion layers 633. Thus, the epoxy resin is cured. It should be noted that to connect the coaxial cable 650, the FPCs 620 are formed longer in the conveying direction A than the piezoelectric element 630.

The FPCs 620 include a basal plate 621 and a copper foil layer 622. The FPCs 620 are adhered such that the side on which the copper foil layer 622 is formed faces the adhesion layer 633. Thus, the copper foil layers 622 of the FPCs 620 are electrically connected via the electrically conductive adhesion layers 633 to the copper foil layers 632a and 632b of the piezoelectric element 630. As a result, a first conductive layer and a second conductive layer sandwiching the piezoelectric body 631 are formed. These first and second conductive layers function as electrodes for driving the piezoelectric body 631.

Next, as shown in FIG. 11, an epoxy resin is thinly applied to the surface of the basal plate 621 of the FPCs 620. Thus, an adhesion layer 623 and an adhesion layer 624 are formed. It should be noted that the adhesion layers 623 and 624 are formed corresponding to the size of the bonded matching layer 610 and the backing layer in the conveying direction A.

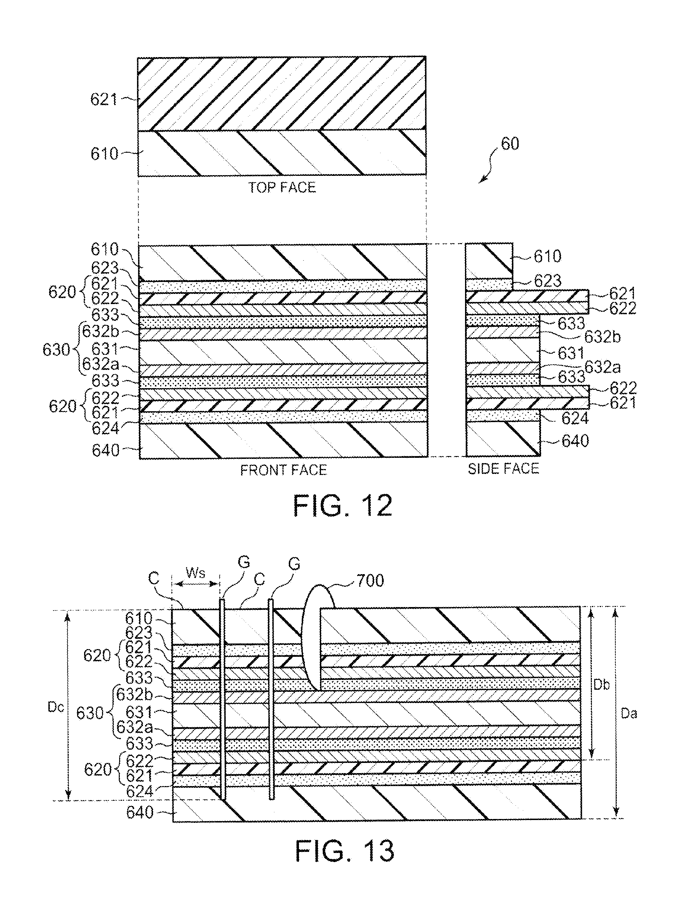

Next, as shown in FIG. 12, the matching layer 610 is adhered to the adhesion layer 623. Moreover, the backing layer 640 is adhered to the adhesion layer 624. That is to say, the matching layer 610 and the FPC 620 are pressed together at suitable pressure while sandwiching the adhesion layers 623. Moreover, the backing layer 640 and the FPC 620 are pressed together at suitable pressure while sandwiching the adhesion layers 624. Thus, the epoxy resin is cured.

As noted above, the length of the matching layer 610 in the conveying direction A (sensor length Ls) is determined in accordance with the length of the detected foreign material in the conveying direction A.

To manufacture the matching layer 610, first, a liquid epoxy resin is stirred and defoamed. The liquid epoxy resin is poured into a mold. Thus, the liquid epoxy resin is cured in plate shape. The cured epoxy resin is lapped (its thickness is polished down) to a predetermined thickness D, and processed into a substrate. The substrate is cut based on the sensor length Ls and sensor width Wa determined by the above-described method. Thus, a matching layer 610 is formed, which has a width Wa, a length Ls and a thickness D.

As noted above, an ordinary industrial-use epoxy resin is used for the matching layer 610, so that the materials are inexpensive, and also the receiving sensor can be manufactured at low cost.

With the above-noted steps, a sensor (layered body) in which the matching layer 610, the FPCs 620, the piezoelectric layer 630 and the backing layer 640 are layered one upon the other can be formed. It should be noted that this configuration is the same for the transmission sensor 50.

Next, the dicing process is explained. FIG. 13 is a partial sectional view to illustrate a method for manufacturing a sensor of the foreign material detecting device 135 shown in FIG. 4.

The sensor (layered body) with the thickness Da manufactured by the steps shown in FIGS. 8 to 12 is provided with incisions with a dicing blade 700 to a predetermined depth Dc, parallel to the sensor length direction (the conveying direction A when the sensor is installed). In this case, the incisions are performed from the side of the matching layer 610 at spacings of the sensor width Ws illustrated in FIG. 7.

The depth Dc is less than the thickness Da of the sensor, and is equal to or greater than the thickness Db from the copper foil layer 622 of the FPC 620 on the side of the backing layer 640 to the matching layer 610. The channels formed with the incisions in this manner are electrically separated from each other. Through the above-described process, it is possible to manufacture a receiving sensor 60 including a plurality of channels.

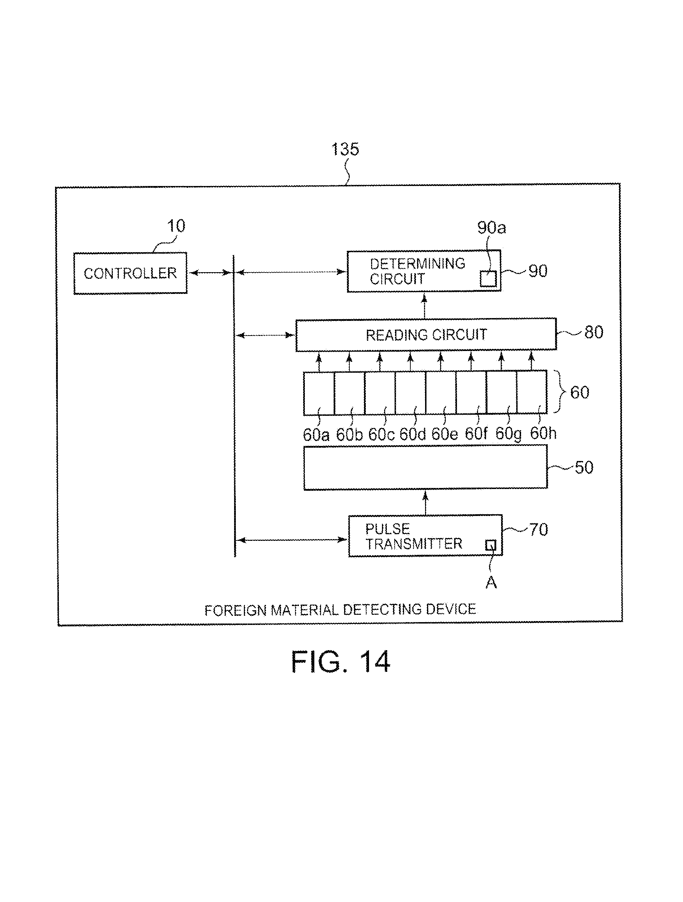

FIG. 14 is a block diagram to illustrate a configuration example of a control system of the foreign material detecting device 135 shown in FIG. 4.

As shown in FIG. 14, the foreign material detecting device 135 includes a controller 10, the transmission sensor 50, the receiving sensor 60, a pulse transmitter 70, a reading circuit 80 and a determining circuit 90. The controller 10, the transmission sensor 50, the receiving sensor 60, the pulse transmitter 70, the reading circuit 80 and the determining circuit 90 are connected to each other via a bus.

The controller 10 performs the overall control of the foreign material detecting device 135. The controller 10 includes, for example, a CPU, a buffer memory, a program memory and a non-volatile memory.

The CPU carries out various kinds of arithmetic processing. The buffer memory temporarily stores the results computed by the CPU. The program memory and the non-volatile memory store various kinds of programs executed by the CPU as well as control data.

The controller 10 can perform various kinds of processes by executing a program stored in the program memory with the CPU. For example, the controller 10 controls the operation timing of the transmission sensor 50 and the receiving sensor 60.

The controller 10 is connected to the CPU 155 of the inspection portion 116 and the main controller 151 show in FIG. 3. For example, the controller 10 can notify processing results to the main controller 151 or the CPU 155. Moreover, the controller 10 can control the operation of the foreign material detecting apparatus 135 based on the control signals sent from the main controller 151 or the CPU 155.

The pulse transmitter 70 generates a pulse signal based on the control of the controller 10. The pulse transmitter 70 enters the generated pulse signal into the transmission sensor 50.

The transmission sensor 50 applies a voltage based on the entered pulse signal to the piezoelectric element 530. Thus, the transmission sensor 50 emits an ultrasonic wave.

The receiving sensor 60 generates an ultrasonic wave detecting signal, based on the operation of the piezoelectric element 630, which follows the oscillation of the matching layer 610. The receiving sensor 60 includes the plurality of channels 60a to 60h. The receiving sensor 60 detects ultrasonic waves from each of these channels, and generates corresponding detection signals. It should be noted that the number of channels is merely an example, and the channel number and the size of each channel may be determined in accordance with the resolution of the receiving sensor 60.

If there is a sheet 7 present between the transmission sensor 50 and the receiving sensor 60, then the receiving sensor 60 detects a transmission wave that has been emitted from the transmission sensor 50 and transmitted through the sheet 7. Furthermore, if there is foreign material 8 present on the sheet 7, then the receiving sensor 60 detects a transmission wave that has been emitted from the transmission sensor 50 and transmitted through the sheet 7 and the foreign material 8.

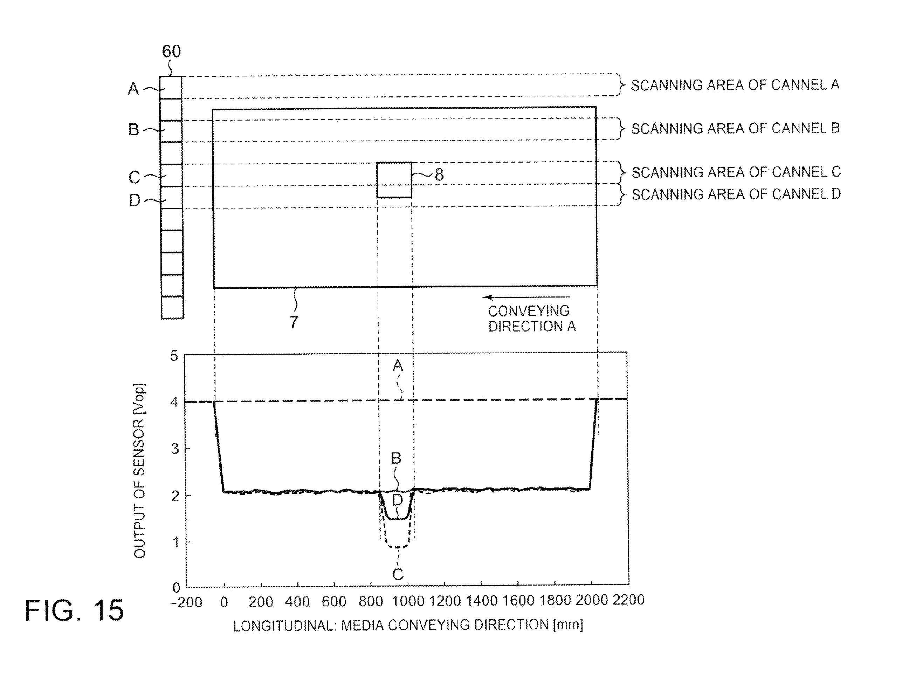

The reading circuit 80 reads the detection signals detected by the plurality of channels 60a to 60h. The reading circuit 80 reads the detection signals received from the receiving sensor 60 at predetermined intervals. Thus, the reading circuit 80 can obtain the detection signals from the entire conveyed sheet 7. For example, the reading circuit 80 may obtain a detection signal as shown in FIG. 15.

FIG. 15 is a diagrammatic view showing a graph and signals detected by the foreign material detecting device 135 shown in FIG. 4. In the graph in FIG. 15, the vertical axis marks the intensity of the signal detected by each channel (the sensor output), and the horizontal axis marks the conveying distance of the sheet 7 (the detection range on the sheet 7).

The foreign material detecting apparatus 135 irradiates ultrasonic waves with the transmission sensor 50 onto the sheet 7 conveyed on the conveying route 115. The individual channels of the receiving sensor 60 detect a transmission wave that is transmitted through the sheet 7 from a predetermined range. Thus, each of the channels of the receiving sensor 60 outputs a sensor output to the reading circuit 80.

The waveform A represents the detection signal detected by the channel A, which scans range outside the conveying range of the sheet 7. The waveform B represents the detection signal detected by the channel B, which scans a range within a conveying range of the sheet 7 to which no tape 8 is stuck. The waveform C represents the detection signal detected by the channel C, which scans a range within a conveying range of the sheet 7 that is included in the region to which a tape 8 is adhered. The waveform D represents the detection signal detected by the channel D, which scans a range within a conveying range of the sheet 7 that includes an edge portion of the tape 8.

As shown by the waveform A, if an ultrasonic wave is detected outside the conveying range of the sheet 7, the channel A directly detects the ultrasonic wave that is output from the transmission sensor 50. In this case, there is no material present that attenuates the ultrasonic wave. Therefore, the channel A detects the ultrasonic wave always at a high level.

As shown by the waveform B, within the conveying range of the sheet 7, if an ultrasonic wave is detected from a region to which no tape 8 is stuck, then the channel B detects a transmission wave that is transmitted through the sheet 7. That is to say, the ultrasonic wave that is output from the transmission sensor 50 is transmitted through the sheet 7 and irradiated onto the channel B. In this case, the channel B detects the ultrasonic wave at a level that corresponds to the attenuation rate of the ultrasonic wave due to the sheet 7.

As shown by the waveform C, if an ultrasonic wave is detected that is within the conveyance range of the sheet 7 and within a range to which a tape 8 is stuck, then the channel C detects a transmission wave that is transmitted through the sheet 7 and the tape 8. That is to say, the ultrasonic wave that is output from the transmission sensor 50 is transmitted through the sheet 7 and the tape 8, and is irradiated onto the channel C. In this case, the channel C detects the ultrasonic wave at a level that corresponds to the attenuation rate of the ultrasonic wave due to the sheet 7 and the tape 8.

As shown by the waveform D, if an ultrasonic wave is detected that is within the conveyance range of the sheet 7 and within a range including an edge of the tape 8, then the channel D detects a combined wave of a transmission wave that is transmitted through the sheet 7 and a transmission wave that is transmitted through the sheet 7 and the tape 8. That is to say, a transmission wave that has been output from the transmission sensor 50 and transmitted through the sheet 7 as well as a transmission wave that has been transmitted through both the sheet 7 and the tape 8 are irradiated onto the channel D. In this case, the channel D detects a supersonic wave of a level that is intermediate between those of graph B and graph C.

The determining circuit 90 includes a reference value memory 90a in which a reference value has been stored in advance. The determining circuit 90 compares the signal obtained with the reading circuit 80 with the reference value stored in the reference value memory 90a. Based on the comparison result, the determining circuit 90 determines whether foreign material 8 is sticking to the sheet 7.

That is to say, if the detection signal obtained from the channels with the reading circuit 80 is equal to or greater than the reference value stored in the reference value memory 90a, then the determining circuit 90 determines that there is no foreign material 8 present. And if the detection signal obtained from the channels with the reading circuit 80 is smaller than the reference value stored in the reference value memory 90a, then the determining circuit 90 determines that there is foreign material 8 present.

Furthermore, based on the positions where the detection signals for the determination are detected, the determining circuit 90 can specify the range over which the foreign material 8 adheres to the sheet 7.

As explained above, in the method for manufacturing an ultrasonic sensor according to this embodiment, a pair of FPCs 620 is bonded to both sides of a piezoelectric element 630. Thus, the first copper foil layer 632a and the second copper foil layer 632b of the piezoelectric element 630 are electrically connected to the respective copper foil layers 622 of the FPCs 622, forming the electrodes. Moreover, the backing layer 640 is bonded to one of the FPCs 620. Furthermore, the matching layer 610 is formed based on the sensor length and the sensor width in correspondence with the desirable detection range. That is to say, the substrate for the matching layer 610 is cut based on the sensor length and the sensor width. The cut matching layer 610 is bonded to the other FPC 620. Through this process, it is possible to manufacture the transmission sensor 50.

Moreover, incisions G are cut into the layered body manufactured by the above-described process to a depth extending from the matching layer 610 at least to the copper foil layer 622 of the FPC 620 on the side of the backing layer 640, parallel to the conveying direction A. Thus, a plurality of channels C including a piezoelectric element 630 and a matching layer 610 can be formed on a common backing layer 640. As a result, a receiving sensor 60 having a plurality of channels C can be manufactured.

With the above-described method, it is possible to change the sensor length of the receiving sensor 60 by changing the size of the matching layer 610 cut from the substrate. Thus, it is possible to manufacture a receiving sensor having a detection range in accordance with the desired resolution. As a result, a method for manufacturing a supersonic sensor, a supersonic sensor and a banknote handling apparatus comprising a supersonic sensor are provided, with which the resolution of the sensor can be easily changed.

With the above-described method, the components other than the matching layer 610 can be standardized. That is to say, it is not necessary anymore to provide FPCs 620, piezoelectric elements 630 and backing layers 640 of different sizes according to the specifications. Thus, it is possible to reduce the costs for manufacturing a plurality of ultrasonic sensors having different resolutions.

In the above-described embodiment, it was explained that incisions G are cut into the layered body in parallel to the conveying direction A at a depth that reaches from the matching layer 610 to the copper foil layer 622 of the FPC 620 on the side of the backing layer 60, however, there is no limitation to this method. For example, it is also possible to provide the incisions G at an angle to the direction parallel to the conveying direction A.

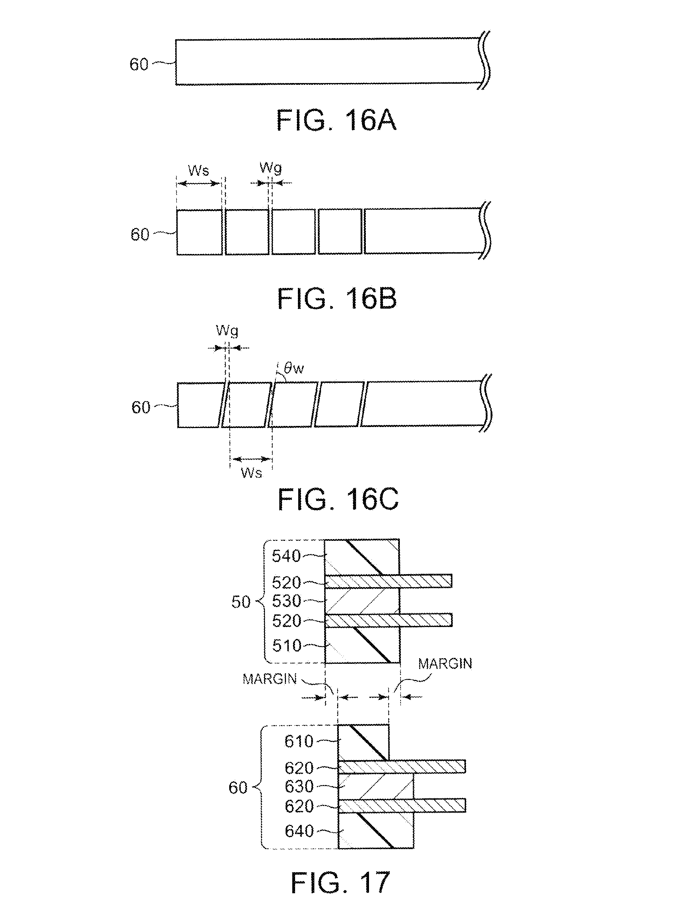

FIGS. 16A to 16C are diagrams to illustrate another dicing example of the receiving sensor 60 of the foreign material detecting device 135. FIG. 16A is a diagram showing the receiving sensor 60 at the stage prior to the dicing, seen from the side of the matching layer 610. FIGS. 16B and 16C are diagrams showing the receiving sensor 60 at the stage after the dicing, seen from the side of the matching layer 610.

FIG. 16B shows an example of dicing in a direction parallel to the conveying direction A. When performing the dicing process, there is a certain dicing allowance due to the thickness of the dicing blade 700. As a result, there is a region of a dicing allowance width Wg in the width direction B that cannot be sensed located between the channels formed with the width Ws. Accordingly, the dicing is carried out at an angle θw with respect to the direction parallel to the conveying direction A, as shown in FIG. 16C.

It is preferable that the dicing angle θw is such an angle, that at least the region that cannot be sensed in the width direction B disappears, and the scanning range of adjacent channels 60a and 60b does not overlap. In this case, it can be prevented that a region that cannot be sensed occurs in the width direction B, and that the detection result of the channels 60a, 60b ---- 60n is affected.

In the above-described embodiment, the diffraction amount of the supersonic waves that are output from the transmission sensor 50 changes in accordance with the length of the matching layer 510 of the transmission sensor 50 in the conveying direction A (sensor length). That is to say, if the sensor length is small, the ultrasonic waves that are output from the transmission sensor 50 tend to be diffracted. For this reason, the ultrasonic waves that are output from the transmission sensor 50 tend to spread.

As a result, there is the possibility that errors in the positions at which the transmission sensor 50 and the receiving sensor 60 are placed lead to a loss in ultrasonic waves detected by the receiving sensor 60. Therefore, there is the possibility that such placement errors affect the detection result of the receiving sensor 60.

To address this problem, it is possible to prevent that errors in the placement positions of the transmission sensor 50 and the receiving sensor 60 affect the detection result of the receiving sensor 60 by adjusting the relation between the length of the matching layer 510 of the transmission sensor 50 in the conveying direction A and the length of the matching layer 610 of the receiving sensor 60, for example.

FIG. 17 is a partial sectional view to illustrate another example of the transmission sensor 50 and the receiving sensor 60 of the foreign material detecting device 135 shown in FIG. 4. FIG. 17 is a diagram in which the foreign material detecting device 135 is taken from the width direction B. FIG. 17 shows the transmission sensor 50 and the receiving sensor 60 in a sectional view.

As shown in FIG. 17, the matching layer 510 of the transmission sensor 50 in the conveying direction A is longer than the matching layer 610 of the receiving sensor 60. In this case, even when there is a deviation in the conveying direction A between the position at which the transmission sensor 50 is arranged and the position at which the receiving sensor 60 is arranged, it can be prevented that this deviation influences the detection result of the receiving sensor 60.

That is to say, the matching layer 510 of the transmission sensor 50 has a margin in the conveying direction A. By manufacturing the transmission sensor 50 and the receiving sensor 60 in this manner, it is easy to place the transmission sensor 50 and the receiving sensor 60.

Moreover, in the above-described embodiment, it was explained that the transmission sensor 50 is configured to generate ultrasonic waves using the matching layer 510 and the piezoelectric element 530, which are not partitioned. However, in this case, a large-capacity amplifier A is necessary for the pulse transmitter 70 to drive the piezoelectric element 530, which is of large size. Therefore, there is the possibility of higher costs.

However, the foreign material detecting device 135 may also have a configuration in which the matching layer 510 and the piezoelectric element 530 of the transmission sensor 50 are partitioned by dicing, and the partitioned piezoelectric element 530 is driven by a plurality of amplifiers A.

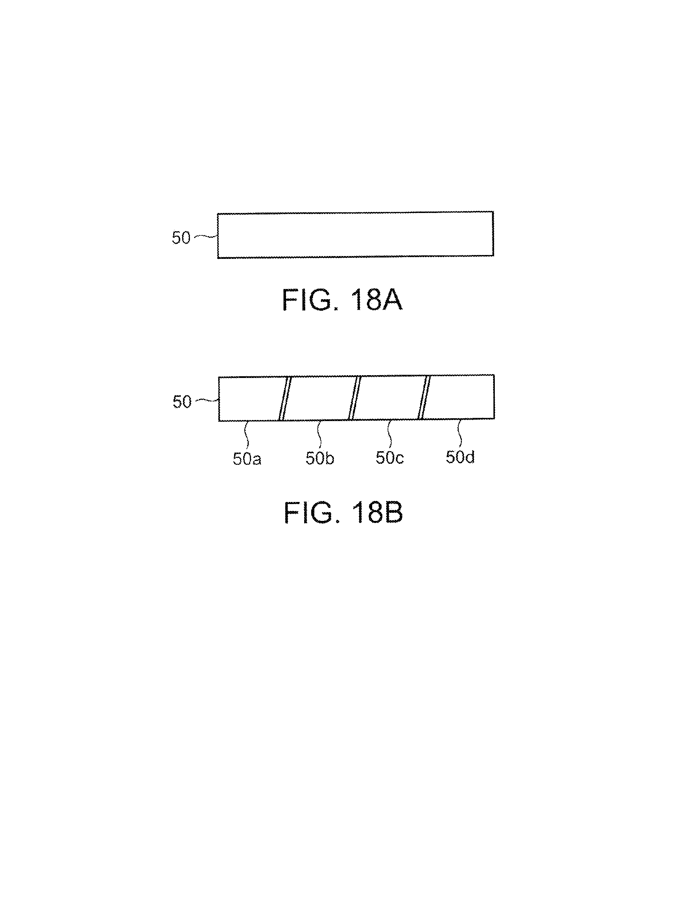

FIG. 18A and FIG. 18B are diagrams to illustrate another configuration example of the transmission sensor 50 of the foreign material detecting device 135 shown in FIG. 4. FIG. 18A and FIG. 18B are diagrams, in which the transmission sensor 50 is viewed from the side of the matching layer 510.

The capacity of the amplifier A of the pulse transmitter 70 that is necessary to drive the transmission sensor 50 shown in FIG. 18A is substantially the same as the sum of the capacities of the amplifiers A that are necessary to drive the channels 50a, 50b, 50c an 50d of the partitioned transmission sensor 50 shown in FIG. 18B.

That is to say, with this configuration, it is possible to reduce the capacity of the amplifiers for driving the channels in accordance with the number of partitions of the transmission sensor 50. As a result, it is possible to reduce the cost of the foreign material detecting device 135.

While certain embodiments have been described, those embodiments have been presented by way of example only, and are not intended to limit the scope of the inventions. Indeed, the novel methods and apparatuses described herein may be embodied in a variety of other forms; furthermore, various omissions, substitutions and changes in the form of the methods and apparatuses described herein may be made without departing from the spirit of the inventions. The accompanying claims and their equivalents are intended to cover such forms or modifications as would fall within the scope and spirit of the inventions.

## Claims

1. A method for manufacturing an ultrasonic sensor, the method comprising:
forming a first conductive layer (632a) on one side of a piezoelectric body (631) having opposing sides;
forming a second conductive layer (632b) on the other side of the piezoelectric body (631);
forming a backing layer (640) on the first conductive layer (632a);
forming a matching layer (610) of a predetermined size on the second conductive layer (632b); and
providing at least one incision (G) through the first conductive layer (632a), the piezoelectric body (631), the second conductive layer (632b) and the matching layer (610), the incision (G) having a depth extending from the matching layer (610) to at least the first conductive layer (632a), to form a plurality of channels (C).

2. The method according to claim 1, wherein a length of the matching layer (610) in a conveying direction of the object to be detected is set based on a size of the object to be detected in the conveying direction of the object to be detected.

3. The method according to claim 2, wherein the length of the matching layer (610) in the conveying direction of the object to be detected is less than half the length of the object to be detected in the conveying direction of the object to be detected.

4. The method according to claim 1, wherein the incision (G) is provided at a depth extending from the matching layer (610) to the first conductive layer (632a) in a direction at a predetermined dicing angle (θw) to the conveying direction of the object to be detected.

5. An ultrasonic sensor, comprising:
a piezoelectric body (631) having opposing sides;
a first conductive layer (632a) formed on one side of the piezoelectric body (631);
a second conductive layer (632b) formed on the other side of the piezoelectric body (631);
a backing layer (640) formed on the first conductive layer (632a);
a matching layer (610) of a predetermined size, formed on the second conductive layer (632b); and
a plurality of channels (C) that are formed by cutting through the matching layer (610), the first conductive layer (632a), the piezoelectric body (631), and the second conductive layer (632b), with at least one incision (G) having a depth extending from the matching layer (610) to at least the first conductive layer (632a).

6. The ultrasonic sensor according to claim 5, wherein a length of the matching layer (610) in a conveying direction of the object to be detected is set based on a size of the object to be detected in the conveying direction of the object to be detected.

7. The ultrasonic sensor according to claim 6, wherein the length of the matching layer (610) in the conveying direction of the object to be detected is less than half the length of the object to be detected in the conveying direction of the object to be detected.

8. The ultrasonic sensor according to claim 5, wherein the incision (G) is provided at a depth extending from the matching layer (610) to the first conductive layer (632a) in a direction at a predetermined dicing angle (θw) to the conveying direction of the object to be detected.

9. A sheet handling apparatus comprising:
a conveying portion (115) to convey a sheet (7);
a transmission portion (50) to emit an ultrasonic wave toward the sheet (7), the transmission portion (50) being longer than a width of the sheet (7) in a direction perpendicular to the conveying direction;
a receiving portion (60) to receive an ultrasonic wave that is transmitted through the sheet (7), the receiving portion (60) being arranged at a position opposite to the transmission portion (50), such that the conveying portion (115) is arranged between the transmission portion (50) and the receiving portion (60), the receiving portion (60) comprising an ultrasonic sensor according to any of claims 5 to 8;
a determining portion (151) to compare detecting signals detected by the plurality of channels (C) of the receiving portion (60) with a reference value stored in advance and determining whether foreign material adheres to the sheet (7), based on a result of that comparison; and
a sorting processing portion (152) to sort the sheets (7) based on the result of the determination by the determining portion (151).

10. The apparatus according to claim 9, wherein the transmission portion (50) comprises:
a piezoelectric body (631) having opposing sides;
a first conductive layer (632a) formed on one side of the piezoelectric body (631);
a second conductive layer (632b) formed on the other side of the piezoelectric body (631);
a backing layer (640) formed on the first conductive layer (632a); and
a matching layer (610) of a predetermined size, formed on the second conductive layer (632b).

11. The apparatus according to claim 10, wherein a length of the matching layer (610) of the transmission portion (50) in a conveying direction of the sheet (7) is at least a length of the matching layer (610) of the receiving portion (60) in the conveying direction of the sheet (7).

12. The apparatus according to claim 9, wherein the transmission portion (50) comprises a plurality of channels (C) that are formed by cutting through the first conductive layer (632a), the piezoelectric body (631), the second conductive layer (632b) and the matching layer (610), with at least one incision (G) having a depth extending from the matching layer (610) to at least the first conductive layer (632a), and
the apparatus further comprises a plurality of amplifiers (A) to respectively drive the channels (C) of the transmission portion (50).

13. The apparatus according to claim 9, wherein a length of the matching layer (610) in the conveying direction is set based on a size of the object to be detected in the conveying direction of the object to be determined.

14. The apparatus according to claim 13, wherein the length of the matching layer (610) in the conveying direction of the object to be detected is less than half the length of the object to be detected in the conveying direction of the object to be detected.

15. The apparatus according to claim 9, wherein the incision is provided at a depth extending from the matching layer (610) to the first conductive layer (632a) in a direction at a predetermined dicing angle to the conveying direction of the object to be detected.
